# EUROPÄISCHE PATENTSCHRIFT

(11) **EP 0 572 791 B1**
(45) Veröffentlichungstag und Bekanntmachung des Hinweises auf die Patenterteilung: **14.12.1994**
(21) Anmeldenummer: 93106592.4
(22) Anmeldetag: 23.04.1993
(51) Int. Cl.: H05K 9/00, G01J 5/06

(54) **Vorrichtung zur Abschirmung einer Elektronik mit Lichtempfänger gegen Störungen**
Device for shielding electronics against disturbance with an optical detector
Dispositif de blindage anti-pertubations d'un récepteur de lumière et de son circuit électronique

(30) Priorität: 29.04.1992 DE 4214036
(43) Veröffentlichungstag der Anmeldung: 08.12.1993
(73) Patentinhaber: ABB PATENT GmbH, 68309 Mannheim (DE)
(72) Erfinder: Wichmann, Ewald, W-5880 Lüdenscheid (DE); Vollmann, Peter, W-5800 Hagen 1 (DE)
(74) Vertreter: Rupprecht, Klaus, Dipl.-Ing.

(56) Entgegenhaltungen:
- EP-A- 0 135 210
- EP-A- 0 407 072
- DE-A- 3 440 739
- DE-A- 3 711 421
- GB-A- 2 200 321

## Beschreibung

Die Erfindung betrifft eine Vorrichtung nach dem Oberbegriff des Anspruchs 1.

Bei vielen Anwendungen, so z. B. bei Bewegungsmeldern, benutzt man optoelektrische Systeme mit einer hochsensiblen Empfangselektronik, die sehr geringe Änderungen der Strahlungsintensität vorzugsweise im Infrarotbereich, noch sicher erfassen müssen. Besondere Schwierigkeiten bereiten dabei Störungen, die durch Fremdlicht und elektromagnetische Störquellen erzeugt werden. Den Einfluß dieser Störquellen auf die empfindliche Empfangselektronik durch geeignete Abschirmung so weit wie möglich auszuschalten, ist eine wichtige Vorraussetung für eine einwandfreie Funktion des jeweiligen optoelektrischen Gerätes (vgl. z. B. DE-A-3440739).

Um dieser Forderung gerecht zu werden, hat man sich bei bekannten Geräten bemüht, die Empfangselektronik möglichst separat in einem eigenen Abschirmkäfig unterzubringen und von anderen Funktionsgruppen, die als Störquellen wirken könnten, zu trennen. Der dadurch bedingte getrennte Aufbau und die zur elektrischen Verbindung erforderlichen Leitungen, die gegebenenfalls noch mit Steckern auszurüsten sind, bedeuten nicht nur einen erhöhten Aufwand, sondern erschweren gleichzeitig auch einen möglichst kompakten Aufbau des Gerätes.

Aufgabe der Erfindung ist es, eine Vorrichtung der im Oberbegriff des Anspruchs 1 genannten Art zu schaffen, die mit geringem Aufwand eine hohe Integration der Bauelemente und damit einen kompakten Aufbau ermöglicht.

Diese Aufgabe wird durch die im Anspruch 1 gekennzeichneten Merkmale gelöst. Zweckmäßige Ausgestaltungen und Weiterbildungen des Erfindungsgegenstandes sind in den Unteransprüchen genannt.

Ein besonderer Vorteil der Erfindung ist, daß die Abschirmung mit Hilfe einer relativ einfach aufgebauten Abschirmhaube erfolgt, die selbst im Bereich des zur Aufnahme der fokussierten Lichtstrahlung dienenden Fensters dadurch eine Abschirmung bewirkt, daß dieses Fenster durch eine Folie abgedeckt ist, die eine elektrisch leitfähige aber lichtdurchlässige Beschichtung besitzt.

Eine zweckmäßige Ausgestaltung des Erfindungsgegenstandes sieht vor, daß das im Rahmen der Schirmwirkung auf der elektrisch leitenden Schicht der Folie entstehende Potential in geeigneter Weise entweder unmittelbar oder durch Kontaktierung mit der Abschirmhaube abgeleitet wird.

Die elektrische Verbindung zwischen der leitenden Folie und der Abschirmhaube wird in einfacher Weise durch gemeinsame Befestigungselemente erreicht. Die Folie wird dabei so über den Lichtdetektor gespannt, daß sie zwischen diesem und dem Fenster der Abschirmhaube liegt.

In einer vorteilhaften Weiterbildung des Erfindungsgegenstandes ist vorgesehen, daß die Abschirmhaube im Bereich einer Außenkante der Leiterplatte befestigt ist und eine senkrecht zur Leiterplatte angeordnete erste Seitenwand der Abschirmhaube über diese Außenkante hinwegragt. Die Länge der Seitenwand ist dabei so gewählt, daß ein Endstück auf der Rückseite der Leiterplatte parallel zu dieser so abgebogen werden kann, daß auch dieser Bereich von der Abschirmwirkung der Abschirmhaube erfaßt wird. So kann die doppelseitig mit Bauelementen bestückte Leiterplatte auch auf der Rückseite abgeschirmt werden.

Um den Biegevorgang, der erst nach der Montage der Abdeckplatte auf der Leiterplatte erfolgt, zu erleichtern, ist die erste Seitenwand entlang der vorgesehenen Biegekante perforiert.

Die Form der Abschirmhaube wird durch ihre vier Seitenwände bestimmt, die von einer das Fenster aufnehmenden Deckwand ausgehen. Zu diesen Seitenwänden gehört eine zur bereits erwähnten ersten Seitenwand paralleliegende zweite Seitenwand, die bis zur Oberfläche der Leiteroberfläche reicht und zwei weitere sich einander gegenüberliegende Seitenwände, die im Bereich ihrer freien Enden nochmals so abgewinkelt sind, daß zur Leiterplatte parallelliegende Befestigungslaschen entstehen. Die Befestigung der Befestigungslaschen auf der Leiterplatte erfolgt mit Hilfe von Nieten.

Wie bereits erläutert, ist die Abschirmhaube so konzipiert, daß sie im Bereich einer Kante, als im Randbereich einer Leiterplatte montiert werden muß. Dadurch gelingt es, auf derselben Leiterplatte weitere Funktionseinheiten zu integrieren und dennoch eine gewisse Trennung, für die auch die Abschirmnaube sorgt, zu gewährleisten.

Die ohnehin vorteilhaften Eigenschaften der Folie, die eine Lichtdurchlässigkeit mit einer elektrischen Leitfähigkeit vereint, werden dadurch noch weiter verbessert, daß ihre Beschichtung so ausgebildet ist, daß sie bevorzugt Infrarotstrahlung durchläßt. So kann Störlicht, das aber dennoch vom Lichtdetektor erfaßt würde, außerhalb des Infrarotbereiches liegt, weitgehend unterdrückt werden.

Ein Ausführungsbeispiel der Erfindung ist in den Zeichnungen dargestellt und wird im folgenden näher beschrieben.

Es zeigen:
- Fig. 1: die auf einer Leiterplatte montierte Abschirmhaube,
- Fig. 2: eine Explosionszeichnung der verschiedenen die Abschirmung bewirkenden Teile.

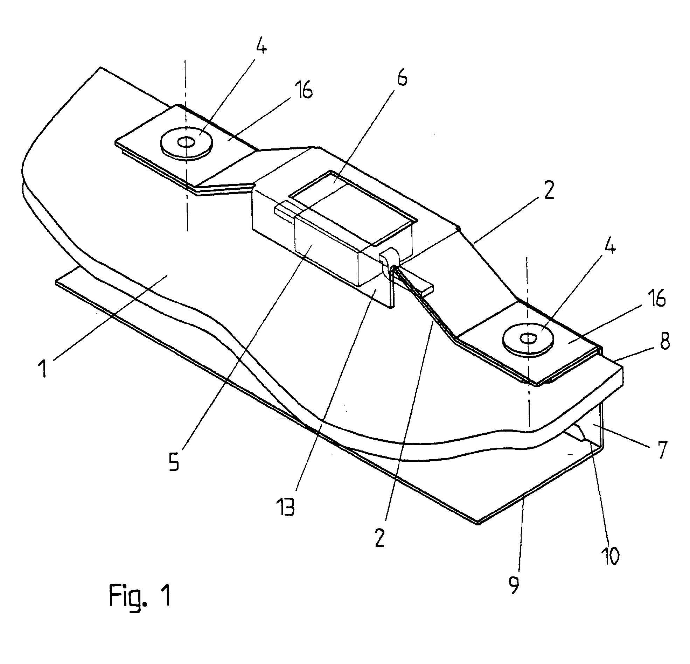

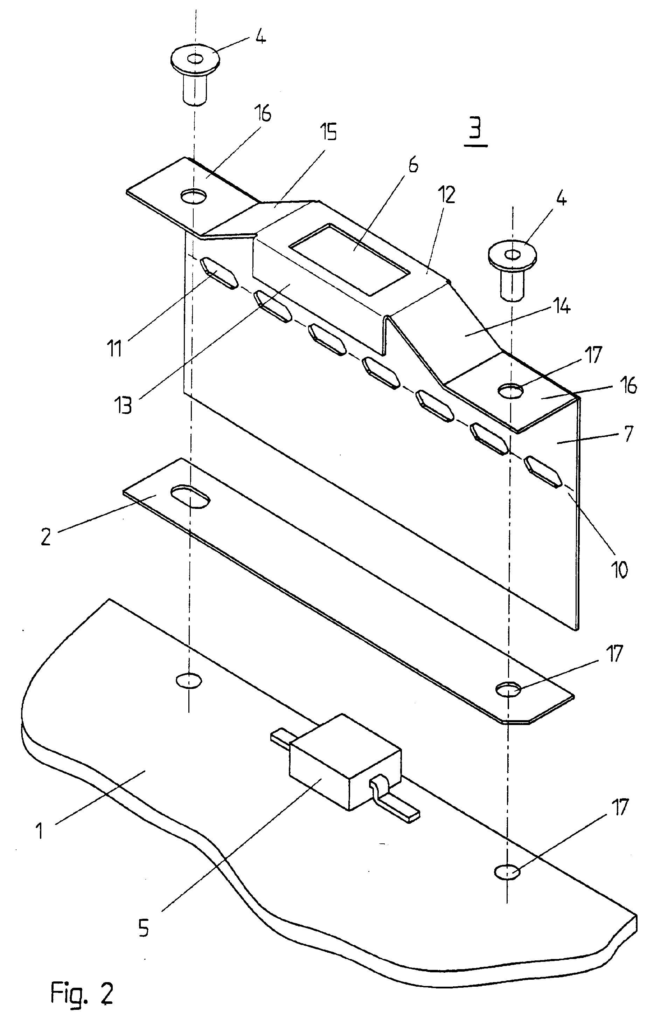

Wie die Figuren 1 und 2 erkennen lassen, ist auf einer Leiterplatte 1 in ihrem Randbereich ein Lichtdetektor 5 montiert. Zur Abschirmung wird über den Lichtdetektor 5 eine beschichtete Folie 2 gelegt, und dann eine Abschirmhaube 3 so aufgesetzt, daß Nieten 4 in miteinander fluchtende Löcher 17 der Teile 1, 2, 3 eingreifen können. Die Nieten 4 bewirken einerseits eine Fixierung und andererseits eine elektrisch leitende Verbindung. So kann das durch die Abschirmwirkung des Metallmantels der Abschirmhaube 3 und der leitenden Beschichtung der Folie 2 aufgebaute Potential über Leiterbahnen der Leiterplatte 1 gegen Masse abgeleitet werden.

Die gezielte Anordnung des Lichtdetektors 5 im Randbereich der Leiterplatte 1 erlaubt es, die Bauelemente der Empfangselektronik von dem ebenfalls auf der Leiterplatte 1 untergebrachten, hier aber nicht dargestellten Bauelementen anderer Funktionseinheiten etwas zu trennen. Gleichzeitig wird dadurch eine besonders zweckmäßige Formgebung für die Abschirmhaube 3 ermöglicht. Diese besitzt eine Deckplatte 12, in der sich ein die Lichtstrahlung zum Lichtdetektor 5 durchlassendes Fenster 6 befindet, und von der vier einen Käfig bildende Seitenwände ausgehen. Von diesen ragt eine erste Seitenwand 7 über eine Kante 8 der Leiterplatte 1 derart hinaus, daß sie auf der Rückseite der-Leiterplatte parallel zu dieser umgebogen werden kann und dadurch eine Abdeckplatte 9 bildet, die auch in diesem Bereich für eine Abschirmung sorgt, so daß weitere zur Empfangselektronik gehörige, auf der zweiseitig bestückte Leiterplatte 1 montierte Bauelemente gegen elektromagnetische Felder geschützt sind. Der Biegevorgang, der nach der Montage der Abdeckhaube 3 mittels der Nieten 4 auf der Leiterplatte 1 erfolgt, wird durch eine Perforation mit Perforierlöchern 11 erleichtert.

Parallel zur ersten Seitenwand 7, dieser gegenüberliegend, schließt sich an die Deckwand 12 eine zweite Seitenwand 13 an, die jedoch nur bis zur Oberfläche der Leiterplatte 1 reicht. Die beiden verbleibenden, sich ebenfalls gegenüberliegenden Seitenwände 14 und 15 der Abdeckhaube 3 sind nicht rechtwinklig, sondern nur im spitzen winkel abgebogen und verlaufen über eine weitere Biegekante jeweils zu einer Befestigungslasche 16, die zur Leiterplatte parallelliegt und damit für eine geeignete Auflage auf dieser sorgt.

## Patentansprüche

1. Vorrichtung zum Empfang von fokussierter Lichtstrahlung mit einem Lichtdetektor (5), insbesondere zum Empfang von Infrarotstrahlung mit einer Infrarotempfangsdiode, und mit weiteren Bauelementen einer Empfangselektronik sowie mit einer vor Fremdlicht und elektromagnetischer Störung schützenden Abschirmung, **dadurch gekennzeichnet,** daß die Abschirmung durch eine auf einer Leiterplatte (1) befestigte, elektrisch leitende Abschirmhaube (3) realisiert ist, deren zur Aufnahme der fokussierten Lichtstrahlung dienendes Fenster (6) durch eine Folie (2) abgedeckt ist, und diese Folie (2) eine elektrisch leitfähige aber lichtdurchlässige Beschichtung besitzt.

2. Vorrichtung nach Anspruch 1, dadurch gekennzeichnet, daß die elektrisch leitende Schicht der Folie (2) mit der Abschirmhaube (3) oder einem hiermit gemeinsamen elektrischen Potential kontaktiert.

3. Vorrichtung nach einem der vorhergehenden Ansprüche, dadurch gekennzeichnet, daß die Folie (2) so über den Lichtdetektor (5) gespannt ist, daß sie zwischen diesem und dem Fenster (6) der Abschirmhaube (3) liegt und durch die gleichen Befestigungselemente (4), wie die Abschirmhaube (3) auf der Leiterplatte fixiert ist.

4. Vorrichtung nach einem der vorhergehenden Ansprüche, dadurch gekennzeichnet, daß die Abschirmhaube (3) im Bereich der Außenkante (8) der Leiterplatte (1) befestigt ist und eine senkrecht zur Leiterplatte (1) angeordnete erste Seitenwand (7) der Abschirmhaube (3) über diese Außenkanten (8) hinwegragt und ein Endstück dieser ersten Seitenwand (7) auf der Rückseite der Leiterplatte (1) parallel hierzu so abgebogen ist, daß sie die doppelseitig mit Bauelementen der Empfangselektronik bestückte Leiterplatte (1) auch in diesem Bereich mit einer Deckplatte (9) abschirmt.

5. Vorrichtung nach Anspruch 1, dadurch gekennzeichnet, daß die erste Seitenwand (7) entlang der für die Deckplatte (1) vorgesehenen Biegekante (10) perforiert ist.

6. Vorrichtung nach einem der vorhergehenden Ansprüche, dadurch gekennzeichnet, daß ausgehend von einer das Fenster (6) der Abschirmhaube (3) aufnehmenden Deckwand (12) vier rechtwinklig zueinander angeordnete Seitenwände so abgebogen sind, daß eine zu ersten Seitenwand (7) parallelliegende zweite Seitenwand (13) bis zur Oberfläche der Leiterplatte (1) reicht und die beiden weiteren sich gegenüberliegenden Seitenwände (14, 15) im Bereich ihrer freien Enden nochmals zu der Leiterplatte (1) parallelliegenden Befestigungslaschen (16) abgewinkelt sind.

7. Vorrichtung nach Anspruch 4, dadurch gekennzeichnet, daß die Befestigung der Befestigungslaschen (16) der Abschirmhaube (3) auf der Leiterplatte (1) mit Hilfe von Mieten (4) erfolgt, die auch für eine elektrische Verbindung der Abschirmung (2, 3) mit einer an Masse liegenden Leiterbahn der Leiterplatte (1) sorgen.

8. Vorrichtung nach einem der vorhergehenden Ansprüche, dadurch gekennzeichnet, daß die Bauelemente der Empfangselektronik nur einen Teilbereich der Leiterplatte (1) in Anspruch nehmen, und auf ihr auch die Bauelemente weiterer Funktionseinheiten integriert sind.

9. Vorrichtung nach einem der vorhergehenden Ansprüche, dadurch gekennzeichnet, daß die Beschichtung der Folie (2) eine spektrale Selektivität bewirkt, durch die von der Folie bevorzugt Infrarotstrahlung durchgelassen wird.

10. Vorrichtung nach einem der vorhergehenden Ansprüche, dadurch gekennzeichnet, daß die Abschirmhaube (3) ein aus Metallblech hergestelltes Stanzteil ist.

## Claims

1. Device for receiving focussed optical radiation having a detector (5), especially for receiving infrared radiation with an infrared receiving diode, and having further components of an electronic reception system as well as having a screening providing protection against extraneous light and electromagnetic interference, characterized in that this screening is formed by an electrically conductive screening hood (3), which is secured on a printed circuit board (1) and the window (6) of which, serving to receive the focussed optical radiation, is covered over by a foil (2), and this foil (2) possesses an electrically conductive but optically transparent coating.

2. Device according to Claim 1, characterized in that the electrically conductive layer of the foil (2) is in contact with the screening hood (3) or an electrical potential in common therewith.

3. Device according to one of the preceding claims, characterized in that the foil (2) is tensioned over the detector (5) so that it lies between the latter and the window (6) of the screening hood (3) and is fixed on the printed circuit board by the same securing element (4) as the screening hood (3).

4. Device according to one of the preceding claims, characterized in that the screening hood (3) is secured in the region of the outer edge (8) of the printed circuit board (1) and a first side wall (7), disposed perpendicular to the printed circuit board (1), of the screening hood (3) projects beyond these outer edges (8) and an end piece of this first side wall (7) is bent over on the rear surface of the printed circuit board (1), parallel thereto, so that it screens the printed circuit board (1), which is equipped on both sides with components of the electronic reception system, in this region also by a cover plate (9).

5. Device according to Claim 1, characterized in that the first side wall (7) is perforated along the bending edge (10) provided for the cover plate (1).

6. Device according to one of the preceding claims, characterized in that, proceeding from a covering wall (12) receiving the window (6) of the screening hood (3), four side walls disposed at right angles to one another are bent over so that a second side wall (13) parallel to the first side wall (7) extends to the surface of the printed circuit board (1) and the two further mutually opposite side walls (14, 15) are angled over again in the region of their free ends to form securing straps (16) parallel to the printed circuit board (1).

7. Device according to Claim 4, characterized in that the securing of the securing straps (16) of the screening hood (3) on the printed circuit board (1) takes place by means of rivets (4) , which also ensure an electrical connection of the screening (2, 3) to a conductor track of the printed circuit board (1), which conductor track is grounded.

8. Device according to one of the preceding claims, characterized in that the components of the electronic reception system take up only a partial region of the printed circuit board (1), and the components of further functional units are also integrated on it.

9. Device according to one of the preceding claims, characterized in that the coating of the foil (2) effects a spectral selectivity, through which infrared radiation is preferentially transmitted by the foil.

10. Device according to one of the preceding claims, characterized in that the screening hood (3) is a stamped part produced from sheet metal.

## Revendications

1. Dispositif pour la réception d'un rayonnement lumineux focalisé, comportant un détecteur de lumière (5), en particulier pour la réception d'un rayonnement infrarouge et comportant une diode de réception dans l'infrarouge, et comportant d'autres éléments constitutifs d'un montage électronique de réception et comportant également un blindage protégeant d'une lumière étrangère et de parasites électromagnétiques, caractérisé en ce que le blindage est réalisé par une coiffe de blindage (3) qui est fixée sur une plaquette de circuit imprimé (1), qui est électriquement conductrice et dont la fenêtre (6) qui sert à la réception du rayonnement de lumière focalisé est recouverte par une feuille (2) et en ce que cette feuille (2) comporte un revêtement électriquement conducteur mais laissant passer la lumière.

2. Dispositif suivant la revendication 1, caractérisé en ce que la couche électriquement conductrice de la feuille (2) est en contact avec la coiffe de blindage (3) ou avec un potentiel électrique commun à celle-ci.

3. Dispositif suivant l'une des revendications précédentes, caractérisé en ce que la feuille (2) est tendue au-dessus du détecteur de lumière (5) de façon qu'elle soit située entre ce dernier et la fenêtre (6) de la coiffe de blindage (3) et qu'elle soit fixée à la plaquette de circuit imprimé par les mêmes éléments de fixation (4) que la coiffe de blindage (3).

4. Dispositif suivant l'une des revendications précédentes, caractérisé en ce que la coiffe de blindage (3) est fixée dans la zone du bord externe (8) de la plaquette de circuit imprimé (1) et en ce qu'une première paroi latérale (7), de la coiffe de blindage (3), agencée perpendiculairement à la plaquette de circuit imprimé (1) fait saillie à l'écart au-delà de ce bord externe (8) et une pièce d'extrémité de cette première paroi latérale (7) est pliée à cet effet parallèlement à la face postérieure de la plaquette de circuit imprimé (1) de façon qu'elle protège également dans cette zone par une plaque de recouvrement (9) la plaquette de circuit imprimé (1) équipée des deux côtés d'éléments constitutifs du montage électronique de réception.

5. Dispositif suivant la revendication 1, caractérisé en ce que la première paroi latérale (7) est perforée le long de l'arête de pliage (10) prévue pour la plaque de recouvrement (9).

6. Dispositif suivant une des revendications précédentes, caractérisé en ce qu'en partant d'une paroi de recouvrement (12) qui loge la fenêtre (6) de la coiffe de blindage (3), quatre parois latérales agencées à angle droit l'une de l'autre sont pliées de façon qu'une seconde paroi latérale (13) située parallèlement à la première paroi latérale (7) arrive jusqu'à la surface de la plaquette de circuit imprimé (1) et de façon que les deux autres parois latérales (14, 15) qui sont situées à l'opposé l'une à l'autre sont encore coudées, dans la zone de leurs extrémités libres, en des pattes de fixation (16) situées parallèlement à la plaquette de circuit imprimé (1).

7. Dispositif suivant la revendication 4, caractérisé en ce que la fixation des pattes de fixation (16) de la coiffe de blindage (3) sur la plaquette de circuit imprimé (1) a lieu à l'aide de rivets (4) qui pourvoient également à une liaison électrique du blindage (2, 3) avec une piste conductrice, de la plaquette de circuit imprimé (1), qui est à la masse.

8. Dispositif suivant l'une des revendications précédentes, caractérisé en ce que les éléments constitutifs du montage électronique de réception n'occupent qu'une zone partielle de la plaquette de circuit imprimé (1) sur laquelle sont également intégrés les éléments constitutifs d'autres ensembles fonctionnels.

9. Dispositif suivant l'une des revendications précédentes, caractérisé en ce que le revêtement de la feuille (2) provoque une sélectivité spectrale par laquelle de préférence un rayonnement infrarouge est admise à passer par la feuille.

10. Dispositif suivant l'une des revendications précédentes, caractérisé en ce que la coiffe de blindage (3) est un élément embouti fabriqué à partir d'une tôle métallique.
